Europäisches Patentamt

European Patent Office

Office européen des brevets

(19)

(11) Veröffentlichungsnummer: **0 302 241 B1**

(12) **EUROPÄISCHE PATENTSCHRIFT**

(45) Veröffentlichungstag der Patentschrift: **26.01.94**

(51) Int. Cl.5: **G01R 31/28**, G01R 31/305

(21) Anmeldenummer: **88110670.2**

(22) Anmeldetag: **04.07.88**

(54) **Spannungsmessung mit einer Elektronensonde ohne externes Triggersignal.**

(30) Priorität: **06.08.87 DE 3726234**

(43) Veröffentlichungstag der Anmeldung:
**08.02.89 Patentblatt 89/06**

(45) Bekanntmachung des Hinweises auf die
Patenterteilung:
**26.01.94 Patentblatt 94/04**

(84) Benannte Vertragsstaaten:
**DE FR GB IT NL**

(56) Entgegenhaltungen:
**EP-A- 0 060 321**

**MICROELECTRONIC ENGINEERING. vol. 7, no.
2-4, 1987, AMSTERDAM NL Seiten 209 - 213;
R.E.Horstman et.al.: "Digital E-beam testing"**

**Scanning vol. 5, 1983, Mahwah, USA Seiten
14 - 24; H.P.Feuerbaum: "Electron beam testing:Methods and application"**

**Scanning electron microscopy vol. 11, 1982,
O Hare IL USA Seiten 563 - 572; M.Ostrow
et.al.: "IC-internal electron beam logic state
analysis"**

(73) Patentinhaber: **SIEMENS AKTIENGESELL-
SCHAFT
Wittelsbacherplatz 2
D-80333 München(DE)**

(72) Erfinder: **Brust, Hans-Detlef
Martin-Luther-Strasse 2
D-6602 Dudweiler(DE)**

**Beschreibung**

Es sind bisher eine Vielzahl von Methoden bekannt, die Signalverläufe periodischer Meßsignale mit dem Elektronenstrahl zu erfassen. Eine Zusammenfassung der zur Zeit gängigen Testverfahren ist in der Veröffentlichung "Microelectronic Engineering" 4 (1986) Seiten 77-106 "Electron Beam Testing" von E. Wolfgang, insbesondere auf Seite 83, wiedergegeben. Man unterscheidet Messungen, die im Zeitbereich und solche, die im Frequenzbereich erfolgen. Zum ersten gehört beispielsweise das "Voltage Coding" (siehe auch "Scanning Electron Microscopy" 1975 (Part I) Proc. of the 8th Annual Scanning Electron Microscope Symposium, Chicago, IIT Research Institute, Seiten 465-471) oder das "Logic State Mapping" (siehe auch US-PS 4 223 220), während zum letzteren das sog. "Frequency-Mapping-Verfahren" gehört.

In beiden Fällen (Messungen im Zeit- und Frequenzbereich) wird in einem Rasterelektronenmikroskop mit Hilfe von Ablenkspulen ein fokussierter Primärelektronenstrahl auf die abzutastende Probenoberfläche geführt. Ein Detektor erfaßt die dabei ausgelösten Sekundärelektronen und in einer Signalkette erfolgt die Auswertung dieses Sekundärsignals.

Bei den meisten Messungen im Zeitbereich ist es erforderlich ein zum Signal im Inneren der Probe, beispielsweise im Inneren eines ICs, synchrones Triggersignal verfügbar zu haben. Ein solches Triggersignal ist notwendig, um in einem Teil einer Signalkette, beispielsweise in einer Meßverarbeitungsanordnung, aus dem sekundären Signal ein Meßsignal durch ein Sampling-oder durch ein kombiniertes Sampling- und Averaging-Verfahren zu gewinnen.

In der Veröffentlichung Scanning Vol. 5, S. 14-24 (1983) "Electron Beam Testing: Methods and Applications" von H.P. Feuerbaum, S. 12-14 wird u.a. die Spannungsmessung nach dem "Wave form measurement"-Verfahren (S. 18-20) erläutert, auf die das erfindungsgemäße Verfahren ebenfalls aufbaut. In Fig. 10 (S. 20) dieser Veröffentlichung ist auch eine Realisierung zu diesem Verfahren mit Hilfe eines Boxcar-Integrators angegeben. Die Blockaufbaustruktur eiines Boxcar-Integrators besteht dabei im wesentlichen aus einer Phasensteuerungseinheit, einer Verzögerungseinheit, einer Torschaltung sowie aus einer Meßverarbeitungseinheit. Ebenfalls gibt die europäische Patentschrift 00 48 858 den Aufbau und die Wirkungsweise eines Boxcar-Integrators wieder.

Viele integrierte Schaltungen weisen jedoch asynchrone Schaltungsteile auf, deren Signale sich in ihrer Frequenz nicht aus den Ansteuerungssignalen gewinnen lassen oder es existieren im Inneren des ICs freilaufende Oszillatoren, deren Signale von außen nicht zugänglich sind. In solchen Fällen steht ein extern erzeugbares Triggersignal nicht zur Verfügung.

Asynchrone Schaltungsteile, wie z.B. freilaufende Oszillatoren, lassen sich zur Zeit nur mit Echtzeitmethoden untersuchen. Der Einsatz von Echtzeitmethoden ist aber auf relativ langsame Signale beschränkt (siehe Scanning Electron Microscopy (1982) "IC-Internal Electron Beam Logic State Analysis" von M. Ostrow, E. Menzel, E. Postulka, S. Görlich, E. Kubalek, S. 563-572). Außerdem ist die erreichbare Genauigkeit wegen des schlechteren Signal-Rauschverhältnisses nicht hoch. Die bei schnellen Signalen gewöhnlich eingesetzte Methode benutzt dagegen ein kombiniertes Sampling- und Averaging-Prinzip. Ein Boxcar-Integrator, der nach dem kombinierten Sampling- und Averaging-Verfahren arbeitet, ist beispielsweise das Modell 162 der Fa. Princeton Applied Research, beschrieben im "Princeton Applied Research Operating and Service Manual". Hierzu ist aber ein Triggersignal zur Steuerung der Meßverarbeitungsanordnung in der Signalkette unabdingbar.

Der Erfindung liegt die Aufgabe zugrunde, Verfahren und Vorrichtungen anzugeben, bei denen eine Spannungsmessung mit der Elektronensonde ohne ein extern generiertes oder ein aus einer Peripherieschaltung, beispielsweise einer Ansteuerschaltung, gewonnenes Triggersignal durchgeführt wird.

Diese Aufgaben werden durch Verfahren nach den Ansprüchen 1 und 5 sowie durch die Vorrichtungen nach den Ansprüchen 8, 12 und 16 gelöst.

Weitere Ausführungen sowie Realisierungen zum erfindungsgemäßen Verfahren sind Gegenstand der Unteransprüche und werden dort näher erläutert.

Die mit der Erfindung erzielten Vorteile liegen darin, daß zur Durchführung des Verfahrens nach der Erfindung die bisher verwendete Anordnung zur Spannungsmessung mit einem externen Triggersignal (z.B. die Anordnung für das "Waveform measurement"-Verfahren in Fig. 10 der schon zitierten Veröffentlichung von H.P. Feuerbaum "Electron Beam Testing: Methods and Applications") im Prinzip unverändert bleibt. Durch die Gewinnung des Triggersignals aus dem Sekundärsignal ist es möglich, Messungen sowohl an synchronen und asynchronen Schaltungsteilen, also auch an freilaufenden Oszillatoren vornehmen zu können, eine Beschränkung, daß das Triggersignal sich aus den Ansteuersignalen der Ansteuerschaltung gewinnen läßt, entfällt.

Mehrere Ausführungsbeispiele sind in den Figuren 1, 2 und 3 dargestellt und werden im folgenden näher beschrieben. Es zeigen:

Fig. 1     eine Vorrichtung zum erfindungsgemäßen Verfahren, wobei das Triggersignal direkt aus dem Sekundärsignal ausgefiltert wird,

Fig. 2 eine Vorrichtung zum erfindungsgemäßen Verfahren, wobei das Triggersignal aus dem Sekundärsignal mit Hilfe einer Synchronisationsschaltung gewonnen wird,

Fig. 3 eine Vorrichtung zum erfindungsgemäßen Verfahren für hohe Frequenzen nach dem "Frequency-Mapping"-Verfahren,

Fig. 4 Signalverlauf des Triggersignals vor dem Strahlaustastgenerator sowie des Triggersignals am Triggereingang der Meßverarbeitungsanordnung beide zur Vorrichtung nach Fig. 1 und 2, und einen Signalverlauf des Triggersignals vor dem Strahlaustastgenerator zur Vorrichtung nach Fig. 4.

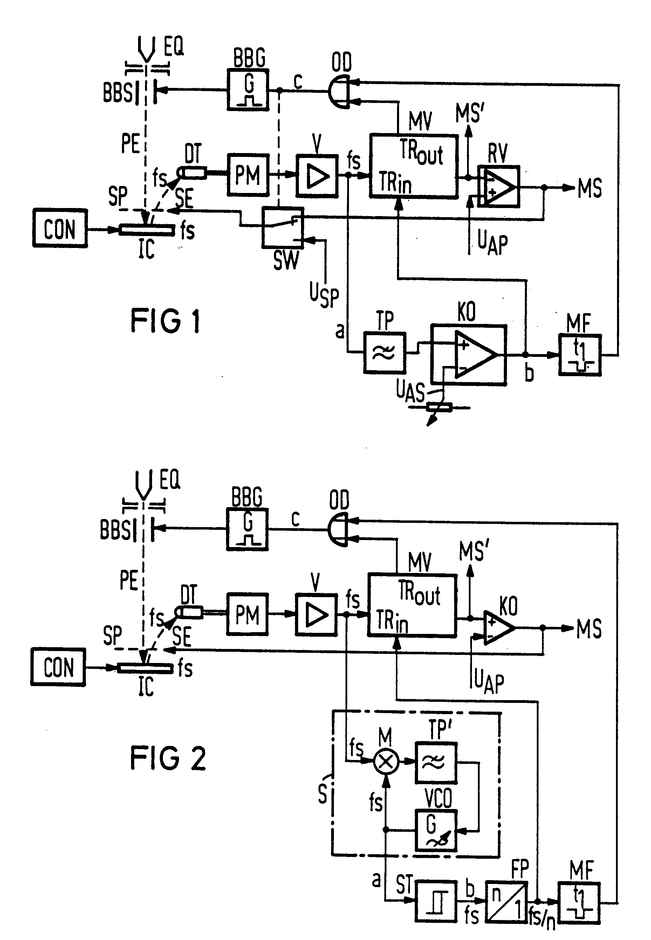

Fig. 1 zeigt eine Vorrichtung für die Spannungsmessung mit der Elektronensonde, wobei das Triggersignal für die Meßverarbeitungsanordnung MV direkt aus dem sekundären Signal ausgefiltert wird. Aus einer Elektronenquelle EQ treten Primärelektronen PE aus, die auf einen Meßpunkt (Leiterbahn) innerhalb eines integrierten Schaltkreises IC auftreffen und dort Sekundärelektronen SE auslösen. Diese Sekundärelektronen SE werden in einem Detektor DT nachgewiesen. In Abhängigkeit von dem Sekundärelektronenstrom, der auf den Detektor DT auftrifft, wird in diesem Detektor ein Sekundärelektronensignal erzeugt, daß zu einem Photomultiplier PM geführt und dort verstärkt wird. Das im Photomultiplier PM verstärkte Sekundärelektronensignal gelangt über einen Vorverstärker V in eine Meßverarbeitungsanordnung MV. Die Meßverarbeitungsanordnung MV in Fig. 1, 2 oder 3 kann beispielsweise durch einen sog. Boxcar-Integrator aufgebaut werden. Am Ausgang der Meßverarbeitungsanordnung MV ist ein Regelverstärker RV angeschlossen. Als Regelverstärker kommen insbesondere P-, PI- oder PID-Regler in Frage. Der Regelverstärker vergleicht das ermittelte Sekundärelektronensignal mit einer Spannung $U_{AP}$, die den Arbeitspunkt der Regelung bestimmt. Am Ausgang des Regelverstärkers wird das Regelsignal abgegriffen und weiter der Steuerelektrode eines Sekundärelektronenspektrometers SP zugeführt. Als Steuerelektrode kommt beispielsweise die Gegenfeldelektrode eines Gegenfeldspektrometers in Frage. Ein solches Gegenfeldspektrometer ist beispielsweise in der US-Patentschrift 4 464 571 beschrieben. Das Ausgangssignal MS des Regelverstärkers bzw. die Spannung an der Gegenfeldelektrode kann dann als Meßsignal dienen. Legt man auf eine exakte Spannungsmessung keinen Wert, sondern will man nur grob den Spannungspegel am jeweiligen Meßpunkt bestimmen, so kann man auf eine Rückkopplungsschaltung auch ganz verzichten und das Ausgangssignal der Meßverarbeitungsanordnung MS direkt als Meßsignal benutzen. In diesem Fall wird die Steuerelektrode des Spektrometers SP entweder auf eine konstante Spannung gelegt oder aber das Spektrometer kann völlig entfallen.

Wenn der Strahl der Primärelektronen PE auf einen Meßpunkt innerhalb der integrierten Schaltung IC oder innerhalb einer sonstigen Probe trifft, und wenn der Meßpunkt ein Signal mit zunächst unbekannter Grundfrequenz fs führt, enthält auch der Strom der Sekundärelektronen SE, der letzten Endes als Sekundärelektronensignal der Meßverarbeitungsanordnung MV zugeführt wird, ein Signalanteil mit der zunächst unbekannten Frequenz fs. Aus diesem Sekundärelektronensignal SE kann daher in der Meßverarbeitungsanordnung MV der Signalanteil mit der zunächst unbekannten Frequenz fs ausgefiltert werden. Zur Versorgung der integrierten Schaltung IC wird diese über die Ansteuerschaltung CON mit den gewünschten Ansteuersignalen versorgt.

Das für die Meßverarbeitungsanordnung MV benötigte Triggersignal wird in Fig. 1 direkt aus dem gemessenen Sekundärelektronensignal ausgefiltert. Zu diesem Zweck wird das Sekundärelektronensignal hinter dem Vorverstärker V und vor der Meßverarbeitungsanordnung MV abgegriffen und einem Bandpaß oder einem Tiefpaß TP zugeführt. Mit Hilfe des Filters TP ist es möglich, die gewünschte Grundfrequenz fs herauszufiltern, die für das Triggersignal entscheidend ist. Unter Umständen kann auch auf ein Filter überhaupt verzichtet werden, da der Detektor, der Photomultiplier und der Vorverstärker, die sich in der Signalkette befinden, selbst ein Tiefpaßverhalten aufweisen. Der Ausgang des Tiefpasses TP ist an einen Schwellwertschalter Ko angeschlossen, der das ausgefilterte Sekundärelektronensignal mit einem Schwellwert $U_{AS}$ vergleicht. Zur Realisierung des Schwellwertschalters Ko wird ein schneller Komparator verwendet, an dessen Pluseingang der Tiefpaßfilter TP und an dessen Minuseingang die Schwellwertspannung $U_{AS}$ angeschlossen ist. Besonders empfehlenswert ist dabei der Einsatz eines Komparators mit Schalthysterese, da dann leichtes Rauschen nicht zu einem Jitter des Triggersignals führt. Außerdem kann es von Vorteil sein, wenn der Komparator eine einstellbare Totzeit aufweist, während der ein Über- bzw. Unterschreiten der Schwellwertschaltung nicht zu einer Änderung des Ausgangssignals des Komparators bzw. zu einem neuen Triggersignal am Ausgang führt. Durch eine solche einstellbare Totzeit kann bei komplizierten Signalen am Meßpunkt eine Fehltriggerung vermieden werden. Der Ausgang dieses Komparators ist sowohl an ein Monoflop MF als auch an den Triggereingang TR$_{IN}$ der Meßverarbeitunganordnung MV angeschlossen. Ein ODER-Gatter OD ist mit seinem ersten Eingang mit dem Monoflop MF und mit seinem zweiten Eingang mit der Meßverarbeitungsanordnung MV über den Triggerausgang TR$_{OUT}$ verschaltet und speist mit seinem Ausgang den Generator BBG zur Ansteuerung eines Ein/Austastsystems BBS. Es empfiehlt sich bei dieser Anordnung die Spannung an der Steuerelektrode des Spektrometers zur Gewinnung des Triggersignals auf einen konstanten Wert zu legen, damit nicht durch eine veränderte Spannung an der Steuerelektrode der Triggereinsatzzeitpunkt verschoben wird. Hierzu dient der Schalter SW, der die Rückkopplung für die eigentliche Spannungsmessung wieder schließt und ansonsten die konstante Spannung U$_{SP}$ an die Gegenfeldelektrode anlegt.

Liegt am Ausgang des Komparators Ko im Punkt b kein Triggersignal an, so wird der Primärelektronenstrahl PE über das Strahlaustastsystem BBS, dem Generator BBG, dem ODER-Gatter OD und dem Monoflop MF zur Gewinnung des Triggersignals ständig eingetastet. Zur eigentlichen Spannungsmessung wird ein Triggersignal aus dem Sekundärelektronensignal SE über den Tiefpaß TP und den Komparator Ko ausgefiltert und der Meßverarbeitungsanordnung MV und dem Monoflop MF zugeführt. Aufgrund dieses Triggersignals tastet das Monoflop MF über das ODER-Gatter OD, den Generator BBG und den Strahlaustastsystem BBS für eine Zeitdauer von t$_1$ (Zeitfenster) den Primärelektronenstrahl PE aus. Während dieses Zeitfensters wird von der Meßverarbeitungsanordnung MV ein zweites Triggersignal aufgrund des ersten an das ODER-Gatter OD abgegeben und die Spannungsmessung durch einen kurzen Primärelektronenimpuls durchgeführt. Nach der Zeitdauer t$_1$ ist der Primärelektronenstrahl PE zur Synchronisation wieder ständig eingetastet. Die Zeitauflösung der Messung wird dabei nur noch durch die Dauer des Primärelektronenimpulses bestimmt.

Ist das Sekundärelektronensignal SE sehr stark verauscht, kann dies selbst bei Einsatz eines Komparators mit Schalthysterese zu einem starken Jittern des Triggersignals und zu einer Verfälschung des Meßergebnisses führen. In diesem Falle ist es sinnvoller, mit Hilfe eines spannungsgeregelten Frequenzoszillators ein zweites Hilfssignal mit dem zu messenden Sekundärelektronensignal zu synchronisieren und von diesem Hilfssignal ein Triggersignal abzuleiten. Fig. 2 zeigt eine dazu geeignete Anordnung. Das Sekundärelektronensignal wird dazu einer Synchronisationsschaltung S zugeführt, die das zur Grundfrequenz des zu messenden Sekundärelektronensignals synchrone Hilfssignal erzeugt.

Die Schaltung nach Fig. 2 entspricht bis auf die Synchronisationsschaltung S, der nachgeschalteten Schmitt-Triggerschaltung ST und dem Frequenzteiler FP der Schaltung nach Fig. 1. Aus diesem Grunde sind die übrigen Bezugzeichen der Schaltungsteile mit den Bezugszeichen der Schaltungsteile nach Fig. 1 identisch. Der Eingang der Synchronisationsschaltung S ist mit einem Punkt der Signalkette nach dem Vorverstärker V und vor der Meßverarbeitungsanordnung MV verbunden, während am Ausgang der Synchronisationsschaltung S eine Schmitt-Triggerschaltung ST bzw. eine Komparatorschaltung und an dieser ein Frequenzteiler FP, der die Frequenz des zweiten Hilfssignals auf den n-ten Teil (n = ganze Zahl) reduziert, angeschlossen ist. Der Ausgang des Frequenzteilers FP ist sowohl mit dem Monoflop MF als auch mit dem Triggereingang TR$_{IN}$ der Meßverarbeitungsanordnung MV verbunden. Die Synchronisationsschaltung S enthält einen Phasendetektor, hier realisiert durch eine Mischstufe M und einen Tiefpaß TP', und einen spannungsgeregelten Frequenzoszillator VCO. Der Phasendetektor, dessen erster Eingang den Eingang der Synchronisationsschaltung S bildet und dessen zweiter Eingang mit dem Ausgang des spannungsgesteuerten Frequenzoszillators VCO verbunden ist und gleichzeitig den Ausgang der Synchronisationsschaltung S bildet, vergleicht die Frequenz der beiden an seinen Eingängen anliegenden Signale. Dazu werden die beiden Signale in der Mischstufe M multiplikativ verknüpft. Der Ausgang der Mischstufe ist an den Tiefpaß TP' angeschlossen. Mit Hilfe dieses Tiefpasses TP' werden lediglich Signale mit der Differenzfrequenz, gebildet aus den Signalen am ersten und zweiten Eingang der Mischstufe M an den nachgeschalteten spannungsgeregelten Frequenzoszilaltor VCO weitergeleitet. Durch die aus dem Phasendetektor und dem spannungsgeregeltem Frequenzoszillator VCO bestehende Regelungsschaltung wird das zweite generierte Hilfssignal am Ausgang der Synchronisationsschaltung S synchron zur Frequenz des Sekundärelektronensignals am Eingang der Synchronisationsschaltung S geregelt. An die Stelle des aus Mischstufe M und Tiefpaß TP' bestehenden Phasendetektors können selbstverständlich auch andere Realisierungen eines Phasendetektors treten, wie sie beispielsweise im Tietze/Schenk, Halbleiterschaltungstechnik, 5. Auflage (1980) S. 709-712, Kapitel: Frequenzempfindlicher Phasendetektor beschrieben sind.

Zur Synchronisation muß der Primärelektronenstrahl PE ständig wie in Fig. 1 eingetastet sein. Zur eigentlichen Spannungsmessung nach dem Samplingprinzip darf nur ein kurzer Primärelektronenimpuls erzeugt werden, um eine hohe Zeitauflösung zu erhalten. Daher wird der Primärelektronenstrahl PE bei jeder n-ten Periode des Sekundärelektronensignals über einen Frequenzteiler FP und ein Monoflop MF für die Dauer des zu messenden

Zeitfensters $t_1$ ausgetastet. Während dieser Zeit erzeugt die Meßverarbeitungsanordnung MV, wie bereits bei Fig. 1 beschrieben, ein zweites Triggersignal und ermittelt dabei mit hoher Zeitauflösung die Spannung am Meßort. Die kurze Zeit während der der Primärelektronenstrahl PE ausgetastet ist, stört die träge Synchronisationsschaltung, die in diesem Falle als PLL-Schaltung ausgebildet ist, und damit die Synchronisation nicht. Mit Hilfe dieser Anordnung ist es möglich, Signale, deren Grundfrequenz kleiner als die Bandbreite der Signalkette (Detektor DT, Photomultiplier PM, Vorverstärker V) ist zu messen. Falls die PLL-Schaltung nach der Auflösung eines Triggerimpulses und damit einer Spannungsmessung hinreichend schnell wieder einschwingt, kann auf den Frequenzteiler FP auch ganz verzichtet werden. In diesem Fall wäre n = 1.

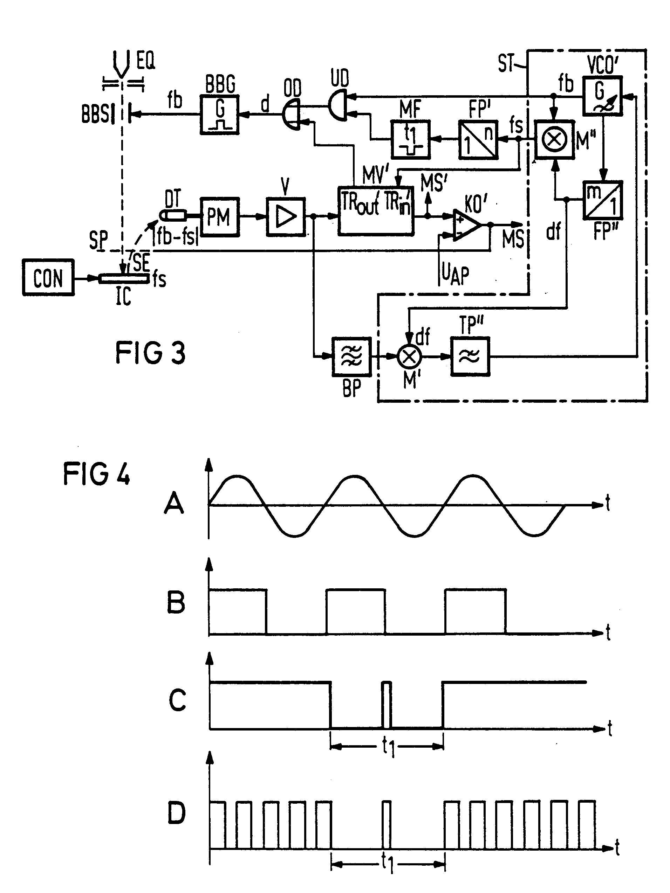

Liegt die Grundfrequenz höher, muß man die PLL-Schaltung unter Einbeziehung des Primärelektronenstrahls PE selbst aufbauen. Fig. 3 zeigt eine entsprechende Meßanordnung. Der mit der Frequenz fb gepulste Primärelektronenstrahl PE mischt das zu messende Signal auf die feste Zwischenfrequenz df, die so niedrig sein muß, daß sie von der Signalkette übertragen werden kann, und ein zum Strahlaustastgenerator synchroner zweiter Generator (hier durch eine einfache Frequenzteilung realisert) erzeugt daraus mit Hilfe einer weiteren Mischstufe M' das Regelsignal für den als spannungsgeregelten Frequenzoszillator ausgeführten Strahlaustastgenerator. Man mischt nicht direkt auf ganz niedrige Frequenzen, da dies der Frequenzbereich des ebenfalls im Sekundärelektronensignal enthaltenen Topographieanteils ist. Nun wird wieder bei jeder n-ten Periode der Primärelektronenstrahl PE ausgetastet und ein kurzer Primärelektronenimpuls zur Spannungsmessung erzeugt. Das Triggersignal mit der bestimmten Frequenz fs gewinnt man hierbei durch eine zweite Mischstufe M''. Besonders vorteilhaft ist dabei der Einsatz eines Einseitenstandmischers als Mischstufe M''.

Im Gegensatz zu den in Fig. 1 und 2 angegebenen Schaltungen wird in Fig. 3 der Primärelektronenstrahl PE mit einer bestimmten Frequenz fb moduliert. Ein geeignetes Strahlaustastsystem ist beispielsweise aus der US-Patentschrift 4 169 229 bekannt. Das Strahlaustastsystem BBS wird mit der Frequenz fb von einem Generator BBG angesteuert. Anstelle des Strahlaustastsystems BBS kann auch jedes andere System treten, das eine Intensitätsmodulation des Primärelektronenstrahls bewirkt. Hierfür kommen z.B. auch der Wehnelt-Zylinder der Elektronenquelle EQ in Betracht. Die Frequenz fb bzw. eine ihrer Oberschwingungen ist gegenüber der Frequenz fs bzw. eine ihrer Oberschwingungen, die das zu messende Signal in einem Meßpunkt aufweist, um die Differenz df versetzt.

Die Zahl df ist daher gleich dem Absolutbetrag der Differenz aus den Zahlen k•fb und l•fs (k, l = ganze Zahlen). Da der Meßpunkt ein Signal mit der Frequenz fs führt und da die Primärelektronen mit der Frequenz fb gepulst werden, enthält das Sekundärelektronensignal, wie es über den Detektor DT, über den Photomultiplier PM schließlich zum Ausgang des Vorverstärkers V gelangt, ein Signal mit der Frequenz df. Das Sekundärelektronensignal mit der Frequenz df wird anschließend in dem Bandpaß BP herausgefiltert und in der Synchronisationsschaltung weiterverarbeitet. Die Gewinnung des Signals der Frequenz df erfolgt ähnlich wie beim "Frequency-Mapping"-Meßverfahren, das ausführlich in der Zeitschrift "Microelectronic Engineering", Vol. 2, No. 4, 1985 "Frequency Tracing and Mapping in Theory and Practice", von H.D. Brust und F. Fox auf den Seiten 304-311 beschrieben ist.

Gleiche Schaltungsteile, die in den Figuren 1 und 2 verwendet wurden und in Fig. 3 ebenfalls eingesetzt werden, sind mit den gleichen Bezugszeichen wie in Fig. 1 und 2 versehen. Zur Erzeugung des ersten Triggersignals mit der Frequenz fs für die Meßverarbeitungsanordnung MV' und der Ansteuerung des Generators BBG mit der Frequenz fb zur Modulation des Strahlaustastsystems BBS wird das Sekundärelektronensignal zwischen dem Vorverstärker V und der Meßverarbeitungsanordnung MV' abgegriffen und einem Bandpaß der Mittenfrequenz df zugeführt. Dieser Bandpaß filtert das Sekundärelektronensignal mit der gemischten Frequenz df heraus und leitet es an die Steuerschaltung ST weiter. Die Ausfilterung des Signals der Frequenz df kann auch unter Verzicht auf das Bandpaßfilter BP durch Synchrongleichrichtung erfolgen. Bei geeigneter Dimensionierung des Tiefpaßfilters TP'', das in der Steuerschaltung ST enthalten ist, kann dabei der Bandpaß BP entfallen. Der erste Ausgang der Steuerschaltung ST, der ein Signal der Frequenz fs führt, ist an den Triggereingang TR$_{IN}$' der Meßverarbeitungsanordnung MV' angeschlossen und gleichzeitig über den Frequenzteiler FP' und dem nachgeschalteten Monoflop MF mit einem UND-Gatter UD verbunden. Ähnlich wie bei Fig. 1 kann auch hier unter Umständen auf den Frequenzteiler verzichtet werden. Das UND-Gatter UD ist über seinen zweiten Eingang mit dem zweiten Ausgang der Steuerschaltung ST verbunden, wobei die Steuerschaltung ST an diesem Ausgang ein Signal der Modulationsfrequenz fb liefert. Ein ODER-Gatter OD ist analog wie in den Figuren 1 und 2 verschaltet. Sein erster Eingang ist mit der Meßverarbeitungsanordnung MV' über den Triggerausgang TR$_{OUT}$' verschaltet, während der zweite Eingang mit dem Ausgang des UND-Gatters UD verbunden ist. Der Ausgang des ODER-Gatters OD ist über den Generator BBG mit dem Strahlaustastsystem BBS verbunden und versorgt dieses System außerhalb der Spannungsmessung mit Signalen der Frequenz fb und sonst innerhalb eines Zeitfensters $t_1$ mit einem kurzen Ansteuerungsimpuls.

Die Steuerschaltung ST enthält zwei Mischstufen M′, M″, einen Tiefpaß TP″, einen Frequenzteiler FP″ sowie einen spannungsgeregelten Frequenzoszillator VCO′. Ein solcher spannungsgeregelter Frequenzoszillator VCO′ stellt beispielsweise der Synthesizer Modell HP 8656 A von Hewlett-Packard dar, der zum einen eine feste Frequenz von beispielsweise 10 MHz über einen Quarzoszillator und zum anderen eine von außen spannungsgesteuerte einstellbare Frequenz fb liefern kann. Der Eingang der ersten Mischstufe M′ bildet hierbei gleichzeitig den Eingang der Steuerschaltung ST, während der zweite Eingang der ersten Mischstufe mit dem ersten Eingang der zweiten Mischstufe M″ und dem Frequenzteiler FP″ verschaltet ist. Die Mischstufe M′ und der Tiefpaß TP″ bilden zusammen einen Phasendetektor, der die Frequenzen der an seinen beiden Eingängen anliegenden Signale miteinander vergleicht. Andere Realisierungen eines solchen Phasendetektors sind selbstverständlich ebenfalls einsetzbar. Der Frequenzteiler FP″ teilt das in der Frequenz feste Signal des spannungsgeregelten Frequenzoszillators VCO′ in einem Verhältnis 1:m. Hierzu ist der erste der beiden Ausgänge des spannungsgeregelten Frequenzoszillators mit dem Frequenzteiler verbunden. Der Ausgang der ersten Mischstufe M′ ist über den Tiefpaß TP″ an den spannungsgeregelten Frequenzoszillator VCO′ angeschlossen und steuert so das am zweiten Ausgang des Frequenzoszillators VCO′ anliegende Signal der Frequenz fb. Der zweite Ausgang des Frequenzoszillators VCO′, der zugleich den Ausgang der Steuerschaltung ST bildet, ist weiterhin mit der zweiten Mischstufe M″ über dessen zweiten Eingang verbunden. Der Ausgang der zweiten Mischstufe M″, der ein Signal der Frequenz fs liefert, bildet den ersten Ausgang der Steuerschaltung ST.

Auch bei dieser und bei der in Fig. 2 dargestellten Anordnung kann ähnlich wie in Zusammenhang mit Fig. 1 beschrieben auf eine Rückkopplung ganz verzichtet werden, wenn man nur am prinzipiellen Spannungsverlauf und nicht an einer exakten Spannungsmessung interessiert ist. Außerdem ist es auch bei Fig. 2 und 3 vorteilhaft, zur Erzeugung des Triggersignals die Steuerspannung am Spektrometer auf einen konstanten Wert zu legen. Dazu kann wie bei Fig. 1 gezeigt in die Rückkopplung ein Umschalter SW eingebaut werden.

Fig. 4 zeigt vier Signalverläufe A, B, C, D, die an den entsprechend mit Kleinbuchstaben bezeichneten Stellen a, b, c, d in den Figuren 1, 2 und 3 auftreten. Fig. 4A zeigt den Signalverlauf aus Fig. 1 und 2 jeweils vor dem Komparator Ko bzw. vor der Schmitt-Triggerschaltung ST. Es wurde hierbei ein sinusförmiger Verlauf angenommen, der jedoch anschließend in ein Rechtecksignal umgeformt wird. Dieses Rechtecksignal ist in Fig. 4B zu sehen und tritt in Fig. 1 hinter dem Komparator Ko und in Fig. 2 hinter der Schmitt-Triggerschaltung ST auf. Der Signalverlauf aus Fig. 4C ist in Fig. 1 und Fig. 2 jeweils hinter dem ODER-Gatter OD abgreifbar. Dabei wird vorausgesetzt, daß die Meßverarbeitungsanordnung MV nach Fig. 1 lediglich innerhalb von dritten Rechteckimpulsen (nach Fig. 4B) einen Meßvorgang (siehe Fig. 4C) auslöst. Man erkennt deutlich in der Mitte den kurzen Impuls innerhalb des Meßfenster der Zeitdauer $t_1$. Dieser kurze Impuls erzeugt mit Hilfe des Generators BBG im Strahlaustastsystem BBS jeweils einen kurzen Primärelektronenimpuls. Der kurze Impuls innerhalb des Zeitfensters wird in der Meßverarbeitungsanordnung MV aufgrund des ersten Triggersignals generiert. Außerhalb des Zeitmeßfensters ist es wie bereits erwähnt, zur Gewinnung des ersten Triggersignals notwendig, daß der Primärelektronenstrahl PE ständig eingetastet ist. Aus diesem Grunde ist das Monoflop MF in der Fig. 1 und 2 so ausgelegt, daß es außerhalb des Zeitfensters über das ODER-Gatter OD und den Generator BBG den Primärstrahl ständig eintastet. Fig. 4D zeigt den analogen Signalverlauf für Fig. 3. Auch hier existiert ein Zeitfenster der Zeitdauer $t_1$ innerhalb der die Messung durchgeführt wird. Außerhalb dieses Zeitfensters jedoch wird der Primärelektronenstrahl PE mit einem Signal der Frequenz fb moduliert. Der Signalverlauf nach Fig. 4D ist am Ausgang des ODER-Gatters OD der Fig. 3 abgreifbar. Wie in Fig. 1 und 2 wird der kurze Impuls zur eigentlichen Messung in der Meßverarbeitungsanordnung MV′ generiert.

Wird bei der Detektion der Sekundärelektronen SE in der Abbildung Fig. 1, Fig. 2 oder Fig. 3 ein Spektrometer SP, insbesondere ein Gegenfeldspektrometer, verwendet, wie es beispielsweise aus der US-PS 4 292 519 bekannt ist, so lassen sich quantitative Messungen durchführen. Die Verwendung eines Spektrometers SP ist nicht nur zu Spannungsmessung nützlich. Benützt man keine Rückkopplungsschleife, sondern legt an das Gegenfeldnetz eines Gegenfeldspektrometers eine konstante Spannung an, so werden nur Sekundärelektronen mit einem Potential, das über der der Gegenfeldelektrode liegt, durchgelassen. Dadurch werden Störeinflüsse lokale Felder unterdrückt.

Die Mischung auf eine feste Zwischenfrequenz beruht auf einer nicht-linearen Schaltkennlinie, hervorgerufen durch das Pulsen des Primärelektronenstrahles. Dies kann man aber ebenfalls erreichen, wenn man anstelle der Primärelektronen die Sekundärelektronen bzw. das Sekundärelektronensignal in ihrer Intensität moduliert. Dies ist beispielsweise möglich, indem man die Energieschwelle eines Gegenfeldspektrometers mit der Frequenz fb moduliert. Durch Berücksichtigung der Spektrometer-Kennlinie kann man sogar eine sinusförmige Modulation des Sekundärelektronensignals erreichen, und so eventuelle Schwierigkeiten mit Kreuzmodulationsprodukten, wie sie bei dem beschriebenen Verfahren unter Umständen auftreten, da die Primärelektronen beispielsweise auch mit Rechtecksignalen gepulst werden können, vermeiden. Durch die höheren umzuladenden Kapazitäten und die Energiedispersion der Sekundärelektronen ist die Grenzfrequenz beim Pulsen einer Einrichtung in der Signalverarbeitung geringer. Außerdem wird durch das Spektrometer das Gesichtsfeld eingeschränkt. Analog kann man auch den Fotomultiplier zusammen mit einer Gate-Schaltung betreiben oder im Video-Signalpfad modulieren. In diesem Fall wird die Bandbreite allerdings durch den Szintillator des Detektors stark eingeschränkt.

Natürlich können anstelle eines Primär-/Sekundärelektronenstrahls auch Wechselwirkungen ausgenutzt werden. Dazu zählt beispielsweise die Beeinflussung der von einem Primärelektronen- bzw. Laserstrahl erzeugten Sekundär- bzw. Photoelektronen durch ein magnetisches Feld. Durch Ausnutzung dieses sogenannten "magnetischen Kontrasts" ließe sich etwa die Bewegung magnetischer Domänen in Magnetblasenspeichern untersuchen.

Der Primärstrahl muß keineswegs ein Partikelstrahl sein, sondern kann auch aus einer beliebigen Strahlung bestehen. Benutzt man etwa einen Laserstrahl als Primärstrahl PE und wiederum eine integrierte Schaltung als Probe IC, so kann der Laserstrahl in den pn-Übergängen der Probe IC Elektronen-Loch-Paare und damit freie Ladungsträger erzeugen. Dies macht sich dann in einer Änderung der Stromaufnahme der Probe IC bemerkbar. Wie groß diese Änderung ist, hängt auch vom Schaltzustand des jeweiligen pn-Übergangs ab. Eine periodische Änderung des Schaltzustandes eines pn-Übergangs ließe sich daher leicht durch eine Messung des Versorgungsstromes der Probe IC feststellen. Der Versorgungsstrom der Schaltung bzw. seine Differenz zum Ruhestrom kann in diesem Fall unmittelbar als Meßsignal dienen, ein besonderer Detektor ist nicht erforderlich.

## Patentansprüche

1. Verfahren zur Spannungsmessung mit einem Korpuskularstrahl ohne externes Triggersignal bei dem der Korpuskularstrahl (PE) auf eine ein zeitabhängiges Signal führende Meßstelle einer Probe (IC) gerichtet wird, bei dem ein die Zeitabhängigkeit des Meßstellensignals aufweisendes sekundäres Signal erzeugt wird und bei dem das sekundäre Signal einer Meßverarbeitungsanordnung (MV) zugeführt wird, **dadurch gekennzeichnet,** daß ein erstes Triggersignal aus dem sekundären Signal gewonnen wird, wobei das erste Triggersignal die Austastung des Korpuskularstrahls (PE) während eines ersten Zeitintervalls ($t_1$) bewirkt, daß das erste Triggersignal ein zweites Triggersignal auslöst, wobei das zweite Triggersignal die Erzeugung eines innerhalb des ersten Zeitintervalls ($t_1$) auftretenden Korpuskularstrahlimpulses bewirkt und daß ein durch den Korpuskularstrahlimpuls hervorgerufenes Ausgangssignal (MS) der Meßverarbeitungsanordnung (MV) aufgezeichnet wird.

2. Verfahren nach Anspruch 1 **dadurch gekennzeichnet,** daß ein die Frequenz ($f_S$) des Meßstellensignals aufweisendes erstes Signal aus dem sekundären Signal ausgefiltert und mit einem Schwellenwert ($U_{AS}$) verglichen wird und daß das erste Triggersignal ausgelöst wird, wenn die aus dem ersten Signal und dem Schwellenwert ($U_{AS}$) gebildete Differenz das Vorzeichen wechselt.

3. Verfahren nach Anspruch 1 oder 2, **dadurch gekennzeichnet,** daß das zweite Triggersignal in der Meßverarbeitungsanordnung (MV) ausgelöst wird.

4. Verfahren nach Anspruch 1 oder 3, **dadurch gekennzeichnet,** daß ein zum sekundären Signal synchrones erstes Hilfssignal in einer Synchronisationsschaltung (S) erzeugt wird und daß aus dem ersten Hilfssignal das erste Triggersignal abgeleitet wird.

5. Verfahren nach Anspruch 4, **dadurch gekennzeichnet,** daß aus dem ersten Hilfssignal durch Frequenzteilung ein zweites Hilfssignal erzeugt wird und daß das zweite Hilfssignal als erstes Triggersignal dient.

6. Verfahren zur Spannungsmessung mit einem Korpuskularstrahl ohne externes Triggersignal bei dem der Korpuskularstrahl (PE) auf eine Meßstelle gerichtet wird, die ein eine Frequenz fs aufweisendes Signal fuhrt, bei dem ein erstes Sekundärteilchensignal durch Nachweis der an der Meßstelle ausgelösten Sekundärteilchen (SE) erzeugt und hieraus durch Verstärkung ein sekundäres Signal abgeleitet wird, bei dem die Intensität des Korpuskularstrahls (PE) oder der Strom der Sekundärteilchen (SE) oder das Sekundärteilchensignal mit einer Frequenz fb moduliert wird, wobei die Frequenzen fs und fb der Bedingung k x fs ≠ l x fb mit k, l, = 1,2,... genügen und bei dem das sekundäre Signal einer Meßverarbeitungsanordnung (MV) zugeführt wird,

**dadurch gekennzeichnet,**

daß ein erstes Triggersignal aus dem sekundären Signal gewonnen wird, wobei das erste Triggersignal die Austastung des Korpuskularstrahls (PE) während eines ersten Zeitintervalls ($t_1$) bewirkt, daß das erste Triggersignal ein zweites Triggersignal auslöst, wobei das zweite Triggersignal die Erzeugung eines innerhalb des ersten Zeitintervalls ($t_1$) auftretenden Korpuskularstrahlimpulses bewirkt und daß ein durch den Korpuskularstrahlimpuls hervorgerufenes Ausgangssignal (MS) der Meßverarbeitungsanordnung (MV) aufgezeichnet wird.

7. Verfahren nach Anspruch 6,
**dadurch gekennzeichnet,**
daß ein eine Zwischenfrequenz df = | k x fb - l x fs |mit k, l = 1, 2, ... aufweisendes erstes Signal aus dem sekundären Signal ausgefiltert und zur Regelung eines die Frequenz fb aufweisenden zweiten Signals verwendet wird und daß ein extern generiertes, die Zwischenfrequenz df aufweisendes drittes Signal mit dem zweiten Signal gemischt und daraus daß erste Triggersignal gewonnen wird.

8. Vorrichtung zur Durchführung des Verfahrens nach Anspruch 1, wobei die Vorrichtung eine mit einer Probe (IC) verbundene Ansteuerschaltung (CON), einen Korpuskularstrahlerzeuger (EQ), eine Modulatoreinheit (BBS, BBG) zur Modulation der Intensität des Korpuskularstrahls (PE), einen Detektor (DT) zum Nachweis der an einer Meßstelle ausgelösten Sekundärteilchen (SE), eine dem Detektor (DT) nachgeschaltete Einrichtung (PM, V) zur Erzeugung eines sekundären Signals und eine eingangsseitig mit dem sekundären Signal beaufschlagte Meßverarbeitungsanordnung (MV) enthält,
**dadurch gekennzeichnet,**
daß ein mit dem sekundären Signal eingangsseitig beaufschlagter Schwellwertschalter (KO) mit einem Triggereingang (TR$_{IN}$) der Meßverarbeitungsanordnung (MV) und einem Monoflop (MF) verbunden ist, daß ein erster Eingang eines die Modulatoreinheit (BBS, BBG) ansteuerndes Oder-Gatter (OD) mit dem Ausgangssignal des Monoflops (MF) beaufschlagt ist und daß ein Triggerausgang (TR$_{OUT}$) der Meßverarbeitungsanordnung (MV) mit einem zweiten Eingang des Oder-Gatters (OD) verbunden ist.

9. Vorrichtung nach Anspruch 8,
**dadurch gekennzeichnet,**
daß dem Schwellwertschalter (KO) ein Filter (TP) vorgeschaltet ist.

10. Vorrichtung nach Anspruch 9,
**dadurch gekennzeichnet,**
daß der Schwellwertschalter (KO) einen Komparator enthält, daß ein erster Eingang des Komparators mit dem Filter (TP) verbunden und ein zweiter Eingang mit einer einstellbaren Spannung (U$_{AS}$) beaufschlagt ist und daß der Ausgang des Komparators den Ausgang des Schwellwertschalters (KO) bildet.

11. Vorrichtung nach Anspruch 9 oder 10,
**dadurch gekennzeichnet,**
daß der Komparator Hystereseeigenschaften besitzt.

12. Vorrichtung zur Durchführung des Verfahrens nach Anspruch 1 oder 4, wobei die Vorrichtung eine mit einer Probe (IC) verbundene Ansteuerschaltung (CON), einen Korpuskularstrahlerzeuger (EQ), eine Modulatoreinheit (BBS, BBG) zur Modulation der Intensität des Korpuskularstrahls (PE), einen Detektor (DT) zum Nachweis der an einer Meßstelle ausgelösten Sekundärteilchen (SE), eine dem Detektor (DT) nachgeschaltete Einrichtung (PM, V) zur Erzeugung eines sekundären Signals und eine eingangsseitig mit dem sekundären Signal beaufschlagte Meßverarbeitungsanordnung (MV) enthält,
**dadurch gekennzeichnet,**
daß eine Synchronisationsschaltung (S) mit dem sekundären Signal beaufschlagt ist, daß ein Ausgang der Synchronisationsschaltung (S) über eine Schmitt-Trigger-Schaltung (ST) oder Komparatorschaltung mit einem Triggereingang (TR$_{IN}$) der Signalverarbeitungsanordnung (MV) und einem Monoflop (MF) verbunden ist und daß die Eingänge eines die Modulatoreinheit (BBS, BBG) ansteuernden Oder-Gatters (OD) mit den am Ausgang des Monoflops (MF) und an einem Triggerausgang (TR$_{OUT}$) der Meßverarbeitungsanordnung (MV) abgegriffenen Signalen beaufschlagt sind.

**13.** Vorrichtung nach Anspruch 12,
**dadurch gekennzeichnet,**
daß der Schmitt-Trigger-Schaltung (ST) oder der Komparatorschaltung ein Frequenzteiler (FP) nachgeschaltet ist.

**14.** Vorrichtung nach Anspruch 12 oder 13,
**dadurch gekennzeichnet,**
daß die Synchronisationsschaltung (S) einen Phasendetektor (M, TP') mit nachgeschaltetem spannungsgeregelten Frequenzoszillator (VCO) enthält und daß ein Ausgang des spannungsgeregelten Frequenzoszillators (VCO) mit einem zweiten Eingang des Phasendetektors (M, TP') und der Schmitt-Trigger-Schaltung (ST) oder der Komparatorschaltung verbunden ist.

**15.** Vorrichtung nach einem der Ansprüche 12 bis 14,
**dadurch gekennzeichnet,**
daß der Phasendetektor aus einer Mischstufe (M) und einem der Mischstufe (M) nachgeschalteten Tiefpaßfilter (TP') besteht.

**16.** Vorrichtung zur Durchführung des Verfahrens nach Anspruch 6, wobei die Vorrichtung eine mit der Probe (IC) verbundene Ansteuerschaltung (CON), einen Korpuskularstrahlerzeuger (EQ), einen Detektor (DT) zum Nachweis der an einer Meßstelle ausgelosten Sekundärteilchen (SE), eine mit einem im Detektor (DT) erzeugten Sekundärteilchensignal beaufschlagte Einrichtung (PM, V) zur Erzeugung eines sekundären Signals, eine eingangsseitig mit dem sekundären Signal beaufschlagte Meßverarbeitungsanordnung (MV) und eine Modulatoreinheit (BBS, BBG) zur Modulation der Intensität des Korpuskularstrahls (PE) oder des Stroms der Sekundärteilchen (SE) oder des Sekundärteilchensignals mit einer Frequenz fb enthält, wobei die Frequenz fb der Bedingung k x fs ≠ l x fb mit k, l = 1, 2, ... genügt und fs die Frequenz eines Meßstellensignals bezeichnet,
**dadurch gekennzeichnet,**
daß eine eingangsseitig mit dem sekundären Signal beaufschlagte Steuerschaltung (ST) vorgesehen ist,
daß ein ein erstes Signal der Frequenz fs liefernder erster Ausgang der Steuerschaltung (ST) mit einem Triggereingang (TR'$_{IN}$) der Meßverarbeitungsanordnung (MV) und einem Monoflop (MF) verschaltet ist,
daß ein erster Eingang eines Und-Gatters (UD) mit dem Ausgang des Monoflops (MF) verbunden ist und ein zweiter Eingang des Und-Gatters (UD) mit einem an einem zweiten Ausgang der Steuerschaltung (ST) abgegriffenen zweiten Signal der Frequenz fb beaufschlagt ist und
daß die Eingänge eines die Modulatoreinheit (BBS, BBG) ansteuernden Oder-Gatters (OD) mit den am Ausgang des Und-Gatters (UD) und einem Triggerausgang (TR'$_{OUT}$) der Meßverarbeitungsanordnung (MV) abgegriffenen Signalen beaufschlagt sind.

**17.** Vorrichtung nach Anspruch 16,
**dadurch gekennzeichnet,**
daß die Steuerschaltung (ST) einen eingangsseitig mit dem sekundären Signal beaufschlagten Phasendetektor (M', TP''), einen dem Phasendetektor (M', TP'') nachgeschalteten spannungsgeregelten Frequenzoszillator (VCO'), einen Frequenzteiler (FP'') und eine Mischstufe (M'') enthält, wobei ein Ausgang der Mischstufe (M'') den ersten Ausgang der Steuerschaltung (ST) bildet, daß ein die Frequenz fb aufweisendes Ausgangssignal des Frequenzoszillators (VCO') am Eingang des Frequenzteilers (FP''), an einem ersten Eingang der Mischstufe (M'') und am zweiten Eingang des Und-Gatters (UD) anliegt und
daß zweite Eingänge der Mischstufe (M'') und des Phasendetektors (M', TP'') mit einem die Frequenz df aufweisenden Ausgangssignal des Frequenzteilers (FP'') beaufschlagt sind.

**18.** Vorrichtung nach Anspruch 16 oder 17,
**dadurch gekennzeichnet,**
daß dem Monoflop (MF) ein zweiter Frequenzteiler (FP') vorgeschaltet ist.

**Claims**

**1.** Method for measuring voltage by means of a corpuscular beam without an external trigger signal, in which the corpuscular beam (PE) is directed onto a measuring point, conducting a time-dependent signal, of a specimen (IC), in which a secondary signal exhibiting the time dependence of the measuring point signal is generated, and in which the secondary signal is fed to a measurement processing unit (MV), characterized in that a first trigger signal is obtained from the secondary signal, the first trigger signal effecting the blanking of the corpuscular beam (PE) during a first time interval ($t_1$), in that the first trigger signal triggers a second trigger signal effecting the generation of a corpuscular beam pulse occurring within the first time interval ($t_1$), and in that an output signal (MS) of the measurement processing unit (MV) produced by the corpuscular beam pulse is recorded.

**2.** Method according to Claim 1, characterized in that a first signal exhibiting the frequency ($f_s$) of the measuring point signal is filtered from the secondary signal and compared with a threshold value ($U_{AS}$), and in that the first trigger signal is triggered when there is a change in the sign of the difference formed from the first signal and the threshold value ($U_{AS}$).

**3.** Method according to Claim 1 or 2, characterized in that the second trigger signal is triggered in the measurement processing unit (MV).

**4.** Method according to Claim 1 or ,3, characterized in that a first auxiliary signal which is synchronous relative to the secondary signal is generated in a synchronization circuit (S), and in that the first trigger signal is derived from the first auxiliary signal.

**5.** Method according to Claim 4, characterized in that a second auxiliary signal is generated from the first auxiliary signal by frequency division, and in that the second auxiliary signal serves as the first trigger signal.

**6.** Method for measuring voltage by means of a corpuscular beam without an external trigger signal, in which the corpuscular beam (PE) is directed onto a measuring point which conducts a signal exhibiting a frequency of fs, in which a first secondary particle signal is generated by detecting the secondary particles (SE) released at the measuring point and a secondary signal is derived therefrom by amplification, in which the intensity of the corpuscular beam (PE) or of the flow of the secondary particles (SE), or the secondary particle signal is modulated at a frequency of fb, the frequencies fs and fb satisfying the condition $k \times fs \neq l \times fb$, where $k, l = 1,2,...$, and in which the secondary signal is fed to a measurement processing unit (MV), characterized in that a first trigger signal is obtained from the secondary signal, the first trigger signal effecting the blanking of the corpuscular beam (PE) during a first time interval ($t_1$), in that the first trigger signal triggers a second trigger signal effecting the generation of a corpuscular beam pulse occurring within the first time interval ($t_1$), and in that an output signal (MS) of the measurement processing unit (MV) produced by the corpuscular beam pulse is recorded.

**7.** Method according to Claim 6, characterized in that a first signal exhibiting an intermediate frequency $df = |k \times fb - l \times fs|$, where $k, l =$ 1, 2,..., is filtered from the secondary signal and is used to control a second signal exhibiting the frequency fb, and in that an externally generated third signal exhibiting the intermediate frequency df is mixed with the second signal and the first trigger signal is obtained from this.

**8.** Device for carrying out the method according to Claim 1, the device containing a control circuit (CON) connected to a specimen (IC), a corpuscular beam generator (EQ), a modulator unit (BBS, BBG) for modulating the intensity of the corpuscular beam (PE), a detector (DT) for detecting the secondary particles (SE) released at a measuring point, a device (PM, V) connected downstream of the detector (DT) for generating a secondary signal, and a measurement processing unit (MV) to which the secondary signal is applied on the input side, characterized in that a trigger (KO) to which the secondary signal is applied on the input side is connected to a trigger input ($TR_{IN}$) of the measurement processing unit (MV) and to a one-shot multivibrator (MF), in that the output signal of the one-shot multivibrator (MF) is applied to a first input of an OR gate (OD) driving the modulator unit (BBS, BBG), and in that a trigger output ($TR_{OUT}$) of the measurement processing unit (MV) is connected to a second input of the OR gate (OD).

**9.** Device according to Claim 8, characterized in that a filter (TP) is connected upstream of the trigger (KO).

**10.** Device according to Claim 9, characterized in that the trigger (KO) contains a comparator, in that a first input of the comparator is connected to the filter (TP) and an adjustable voltage ($U_{AS}$) is applied to a second input, and in that the output of the comparator forms the output of the trigger (KO).

**11.** Device according to Claim 9 or 10, characterized in that the comparator has hysteresis characteristics.

**12.** Device for carrying out the method according to Claim 1 or 4, the device containing a control circuit (CON) connected to a specimen (IC), a corpuscular beam generator (EQ), a modulator unit (BBS, BBG) for modulating the intensity of the corpuscular beam (PE), a detector (DT) for detecting the secondary particles (SE) released at a measuring point, a device (PM, V) connected downstream of the detector (DT) for generating a secondary signal, and a measurement processing unit (MV) to which the secondary signal is applied on the input side, characterized in that the secondary signal is applied to a synchronization circuit (S), in that an output of the synchronization circuit (S) is connected via a Schmitt trigger circuit (ST) or comparator circuit to a trigger input (TR$_{IN}$) of the measurement processing unit (MV) and to a one-shot multivibrator (MF), and in that the signals tapped at the output of the one-shot multivibrator (MF) and at a trigger output (TR$_{OUT}$) of the measurement processing unit (MV) are applied to the inputs of an OR gate (OD) driving the modulator unit (BBS, BBG).

13. Device according to Claim 12, characterized in that a frequency divider (FP) is connected downstream of the Schmitt trigger circuit (ST) or the comparator circuit.

14. Device according to Claim 12 or 13, characterized in that the synchronization circuit (S) contains a phase detector (M, TP') with a downstream voltage-controlled frequency oscillator (VCO), and in that an output of the voltage-controlled frequency oscillator (VCO) is connected to a second input of the phase detector (M, TP') and of the Schmitt trigger circuit (ST) or of the comparator circuit.

15. Device according to one of Claims 12 to 14, characterized in that the phase detector comprises a mixing stage (M) and a low-pass filter (TP') connected downstream of the mixing stage (M).

16. Device for carrying out the method according to Claim 6, the device containing a control circuit (CON) connected to the specimen (IC), a corpuscular beam generator (EQ), a detector (DT) for detecting the secondary particles (SE) released at a measuring point, a device (PM, V) for generating a secondary signal, to which a secondary particle signal generated in the detector (DT) is applied, a measurement processing unit (MV) to which the secondary signal is applied on the input side, and a modulator unit (BBS, BBG) for modulating the intensity of the corpuscular jet (PE) or of the flow of secondary particles (SE) or of the secondary particle signal with a frequency of fb, the frequency fb satisfying the condition k × fs ≠ l × fb, where k, l = 1, 2,..., and fs denoting the frequency of a measuring point signal, characterized in that a control circuit (ST) to which the secondary signal is applied on the input side is provided, in that a first output of the control circuit (ST), which supplies a first signal of the frquency fs, is connected to a trigger input (TR'$_{IN}$) of the measurement processing unit (MV) and to a one-shot multivibrator (MF), in that a first input of an AND gate (UD) is connected to the output of the one-shot multivibrator (MF) and a second signal of frequency fb and tapped at a second output of the control circuit (ST) is applied to a second input of the AND gate (UD), and in that the signals tapped at the output of the AND gate (UD) and at a trigger output (TR'$_{OUT}$) of the measurement processing unit (MV) are applied to the inputs of an OR gate (OD) driving the modulator unit (BBS, BBG).

17. Device according to Claim 16, characterized in that the control circuit (ST) contains a phase detector (M', TP'') to which the secondary signal is applied on the input side, a voltage-controlled frequency oscillator (VCO') connected downstream of the phase detector (M', TP''), a frequency divider (FP'') and a mixing stage (M''), an output of the mixing stage (M'') forming the first output of the control circuit (ST), in that an output signal, exhibiting the frequency fb, of the frequency oscillator (VCO') is present at the input of the frequency divider (FP''), at a first input of the mixing stage (M'') and at the second input of the AND gate (UD), and in that an output signal, exhibiting the frequency of df, of the frequency divider (FP'') is applied to second inputs of the mixing stage (M'') and of the phase detector (M', TP'').

18. Device according to Claim 16 or 17, characterized in that a second frequency divider (FP') is connected upstream of the one-shot multivibrator (MF).

**Revendications**

1. Procédé de mesure de la tension à l'aide d'un faisceau corpusculaire sans signal de déclenchement externe, selon lequel on dirige le faisceau corpusculaire (PE) sur un point de mesure d'un échantillon (IC), qui envoie un signal qui dépend du temps,
on produit un signal secondaire, qui possède la dépendance du signal du point de mesure vis-à-vis du temps, et
on envoie le signal secondaire à un dispositif de traitement de mesure (MV),
caractérisé par le fait
qu'un premier signal de déclenchement est obtenu à partir du signal secondaire, le premier signal de déclenchement provoquant l'extinction du faisceau corpusculaire (PE) pendant un premier intervalle de temps (t$_1$),

que le premier signal de déclenchement déclenche un second signal de déclenchement, qui déclenche la production d'une impulsion du faisceau corpusculaire, qui apparaît pendant le premier intervalle de temps ($t_1$), et qu'un signal de sortie (MS), du dispositif de traitement de mesure (MV) qui est provoqué par l'impulsion du faisceau corpusculaire, est enregistré.

2. Procédé suivant la revendication 1, caractérisé par le fait qu'un premier signal, qui possède la fréquence ($f_s$) du signal du point de mesure, est séparé par filtrage du signal secondaire et est comparé à une valeur de seuil ($U_{AS}$),et que le premier signal de déclenchement est déclenché lorsque la différence formée à partir du premier signal et de la valeur de seuil ($U_{AS}$) change de signe.

3. Procédé suivant la revendication 1 ou 2, caractérisé par le fait que le second signal de déclenchement est déclenché dans le dispositif de traitement de mesure (MV).

4. Procédé suivant la revendication 1 ou 3, caractérisé par le fait qu'un premier signal auxiliaire, synchrone avec le signal secondaire, est produit dans un circuit de synchronisation (S) et que le premier signal de déclenchement est dérivé du premier signal auxiliaire.

5. Procédé suivant la revendication 4, caractérisé par le fait qu'un second signal auxiliaire est produit à partir du premier signal auxiliaire par division de la fréquence et que le second signal auxiliaire est utilisé comme premier signal de déclenchement.

6. Procédé de mesure de la tension à l'aide d'un faisceau corpusculaire sans signal de déclenchement externe, selon lequel
on dirige le faisceau corpusculaire (PE) sur un point de mesure, qui envoie un signal possédant une fréquence fs,
on produit un premier signal de particules secondaires par détection des particules secondaires (SE) émises au point de mesure et on en dérive un signal secondaire par amplification, et
selon lequel l'intensité du faisceau corpusculaire (PE) ou le courant des particules secondaires (SE) ou le signal des particules secondaires est modulé avec une fréquence fb, les fréquences fs et fb satisfaisant à la condition k x fs ≠ l x fb avec k, l = 1, 2,..., et
selon lequel le signal secondaire est envoyé à un dispositif de traitement de mesure (MV),
caractérisé par le fait
qu'un premier signal de déclenchement est obtenu à partir du signal secondaire, le premier signal de déclenchement déclenchant l'extinction du faisceau corpusculaire (PE) pendant un premier intervalle de temps ($t_1$),
que le premier signal de déclenchement déclenche un second signal de déclenchement, qui déclenche la production d'une impulsion du faisceau corpusculaire, qui apparaît pendant le premier intervalle de temps ($t_1$), et qu'un signal de sortie (MS) du dispositif de traitement de mesure (MV), qui est déclenché par l'impulsion du faisceau corpusculaire, est enregistré.

7. Procédé suivant la revendication 6, caractérisé par le fait qu'un premier signal, qui possède une fréquence intermédiaire df = |k x fb - l x fs| avec k, l = 1, 2, ..., est séparé par filtrage du signal secondaire et est utilisé pour la régulation d'un second signal possédant la fréquence fb, et qu'un troisième signal produit de façon externe et possédant la fréquence intermédiaire df est mélangé au second signal et que le premier signal de déclenchement en est obtenu.

8. Dispositif pour la mise en oeuvre du procédé suivant la revendication 1, qui comporte un circuit de commande (CON), relié à un échantillon (IC), un générateur (EQ) d'un faisceau corpusculaire, une unité de modulation (BBS, BBG) destiné à moduler l'intensité du faisceau corpusculaire (PE), un détecteur (DT) destiné à détecter les particules secondaires (SE) émises en un point de mesure, un dispositif (PM,V) branché en aval du détecteur (DT) et destiné à produire un signal secondaire et un dispositif de traitement de mesure (MV), dont le côté entrée reçoit par le signal secondaire, caractérisé par le fait
qu'un commutateur à valeur de seuil (KO), recevant à son entrée le signal secondaire, est relié à une entrée de déclenchement ($TR_{IN}$) du dispositif de traitement de mesure (K) et à un multivibrateur monostable (MF),
qu'une première entrée d'une porte OU (OD), qui commande l'unité de modulation (BBS,BBG), reçoit le signal de sortie du multivibrateur monostable (MF), et
qu'une sortie de déclenchement ($TR_{OUT}$) du dispositif de traitement de mesure (MV) est reliée à une seconde entrée de la porte OU (OD).

9. Dispositif suivant la revendication 8, caractérisé par le fait qu'un filtre (TP) est branché en amont du commutateur à valeur de seuil (KO).

10. Dispositif suivant la revendication 9, caractérisé par le fait que le commutateur à valeur de seuil (KO) comporte un comparateur, qu'une première entrée du comparateur est reliée au filtre (TP) et qu'une seconde entrée est chargée par une tension réglable ($U_{AS}$), et que la sortie du comparateur forme la sortie du commutateur à valeur de seuil (KO).

11. Dispositif suivant la revendication 9 ou 10, caractérisé par le fait que le comparateur possède des propriétés d'hystérésis.

12. Dispositif pour la mise en oeuvre du procédé suivant la revendication 1 ou 4, et qui comprend un circuit de commande (CON), relié à un échantillon (IC), un générateur (EQ) d'un faisceau corpusculaire, une unité de modulation (BBS, BBG) destinée à moduler l'intensité du faisceau corpusculaire (PE), un détecteur (DT) destiné à détecter les particules secondaires (SE) émises en un point de mesure, un dispositif (PM,V) branché en aval du détecteur (DT) et destiné à produire un signal secondaire et un dispositif de traitement de mesure (MV), dont le côté entrée reçoit le signal secondaire, caractérisé par le fait
qu'un circuit de synchronisation (S) est chargé par le signal secondaire,
qu'une sortie du circuit de synchronisation (S) est reliée par l'intermédiaire d'un circuit déclencheur de Schmitt (ST) ou d'un circuit de comparateur à une entrée de déclenchement ($TR_{IN}$) du dispositif de traitement de signaux (MV) et à un multivibrateur monostable (MF), et
que les entrées d'une porte OU (OD), qui commande l'unité de modulation (BBS,BBG), reçoivent les signaux prélevés sur la sortie du multivibrateur monostable (MF) et sur une sortie de déclenchement ($TR_{OUT}$) du dispositif de traitement de mesure (MV).

13. Dispositif suivant la revendication 12, caractérisé par le fait qu'un diviseur de fréquence (SP) est branché en aval du circuit déclencheur de Schmitt (ST) ou du circuit comparateur.

14. Dispositif suivant la revendication 12 ou 13, caractérisé par le fait que le circuit de synchronisation (S) contient un détecteur de phase (M,TP'), en aval duquel est branché un oscillateur (VCO) commandé par la tension et qu'une sortie de l'oscillateur (VCO) commandée par la tension est connectée à la seconde entrée du détecteur de phase (M,TP') et au circuit déclencheur de Schmitt (ST) ou au circuit comparateur.

15. Dispositif suivant l'une des revendications 12 à 14, caractérisé par le fait que le détecteur de phase est constitué par un étage mélangeur (M) et par un filtre passe-bas (TF') branché en aval de l'étage mélangeur (M).

16. Dispositif pour la mise en oeuvre du procédé suivant la revendication 6 et qui comporte un circuit de commande (CON) relié à l'échantillon (IC), un générateur (EQ) du faisceau corpusculaire, un détecteur (DT) servant à détecter les particules secondaires (SE) émises en un point de mesure, un dispositif (PM,V) recevant un signal de particules secondaires produit dans le détecteur (DT) et servant à produire un signal secondaire, un dispositif de traitement de mesure (MV) recevant à son entrée par le signal secondaire, et une unité de modulation (BBS, BBG) servant à moduler l'intensité du faisceau corpusculaire (PE) ou du courant de particules secondaires (SE) ou du signal de particules secondaires avec une fréquence fb, la fréquence fb satisfaisant à la condition k x fs ≠ 1 x fb avec k, l = 1, 2, ..., et fs désignant la fréquence d'un signal du point de mesure,
caractérisé par le fait
qu'il est prévu un circuit de commande (ST) recevant dans le côté entrée le signal secondaire,
qu'une première sortie, qui envoie un premier signal de fréquence fs du circuit de commande (ST) est reliée à une entrée de déclenchement ($TR'_{IN}$) du dispositif de traitement de mesure (MV) et à un multivibrateur monostable (MS),
qu'une première entrée d'une porte ET (UD) est reliée à la sortie du multivibrateur monostable (MF) et qu'une seconde entrée de la porte ET (UD) reçoit un second signal de fréquence fb prélevé sur une seconde sortie du circuit de commande (ST), et
que les entrées d'une porte OU (OD), qui commande l'unité de modulation (BBS,BBG), reçoivent les signaux qui sont prélevés sur la sortie de la porte ET (UD) et sur une sortie de déclenchement ($TR'_{OUT}$) du dispositif de traitement de mesure (MV).

17. Dispositif suivant la revendication 7, caractérisé par le fait que le circuit de commande (ST) comporte un détecteur de phase (M',TP''), qui reçoit côté entrée le signal secondaire, un oscillateur commandé par la tension (VCO') branché en aval du détecteur de phase (M',TP''), un diviseur de fréquence (FP'') et un étage mélangeur (M''), une sortie de l'étage mélangeur (M'') formant la première sortie du circuit de commande (ST), qu'un signal de sortie de fréquence fb de l'oscillateur (VCO') est appliqué à l'entrée du diviseur de fréquence (FV''), au niveau d'une première entrée de l'étage mélangeur (M'') et au niveau de la seconde entrée de la porte ET (UD), et
que des secondes entrées de l'étage mélangeur (M'') et du détecteur de phase (M',TP'') reçoivent un signal de sortie de fréquence df du diviseur de fréquence (FP'').

18. Dispositif suivant la revendication 16 ou 17, caractérisé par le fait qu'un second diviseur de fréquence (FP') est branché en amont du multivibrateur monostable (MF).

FIG 1

FIG 2

15

FIG 3

FIG 4